# EUROPEAN PATENT APPLICATION

(11) **EP 4 835 504 A1**
(43) Date of publication of application: **04.11.2026**
(21) Application number: 25848751.1
(22) Date of filing: 11.07.2025
(51) Int. Cl.: G01R 31/392, G01R 31/3835, G01R 31/367, G01R 19/00, G01R 19/10, G01R 19/12, G01R 19/165

(54) **ELECTRONIC DEVICE AND LITHIUM-SULFUR BATTERY STATE OF CHARGE DIAGNOSIS METHOD THEREOF**

(30) Priority: 02.08.2024 KR 20240103139
(71) Applicant: LG Energy Solution, Ltd., Seoul 07335 (KR)
(72) Inventor: YOON, Kyung Sup, Daejeon 34122 (KR)
(74) Representative: Goddar, Heinz J.
(86) International application number: PCT/KR2025/010206
(87) International publication number: WO 2026/029426

(57) **Abstract**

Provided is an electronic device for diagnosing the state of charge of a lithium-sulfur battery. The electronic device may be configured to: acquire, for the lithium-sulfur battery, a plurality of first voltages measured during a first time period and a plurality of second voltages measured during a second time period following the first time period; identify a first change amount of an average voltage over time on the basis of a first average voltage, which is an average of the plurality of first voltages, and a second average voltage, which is an average of the plurality of second voltages; determine, on the basis of the first change amount, whether to accumulate the number of times for diagnosing the state of charge of the lithium-sulfur battery; and diagnose the state of charge of the lithium-sulfur battery on the basis of the accumulated number of times.

## Description

### Technical Field

The present disclosure relates to an electronic apparatus and a method for diagnosing a state of charge of a lithium-sulfur battery, and more particularly, to a technology for diagnosing a state where charging of a lithium-sulfur battery is extremely delayed.

This application claims the benefit of Korean Patent Application No. 10-2024-0103139, filed on August 2, 2024, in the Korean Intellectual Property Office, the disclosure of which is incorporated herein by reference.

### Background Art

A lithium-sulfur battery has a characteristic of frequently experiencing a case where voltage does not rise or voltage rises at a relatively slow speed during charging. This characteristic of the lithium-sulfur battery is a voltage behavior characteristic different from that of an existing battery (for example, a lithium-ion battery (LIB)), and thus, a safety diagnosis technique used for the existing battery may not be identically used. Accordingly, a manner of identifying a charging and discharging profile during a charging and discharging cycle and diagnosing an abnormal behavior of voltage through a comparison with profile data of a previous cycle has been suggested, which, however, has a problem in that if a charging delay occurs during an initial cycle where a little voltage data is collected, diagnosing an abnormal behavior is substantially impossible because previous cycle data is insufficient. Therefore, there is a growing need for a manner of initially diagnosing a charging delay issue that occurs during charging and discharging of a lithium-sulfur battery.

### Description of the Invention

### Technical Goals

Example embodiments of the present disclosure are conceived to solve the foregoing problem and provide an electronic apparatus and a method for diagnosing a state of charge of a lithium-sulfur battery.

Example embodiments are not limited to the technical goals described above, and other technical goals may be inferred from the following example embodiments.

### Technical solutions

According to an example embodiment, provided is an electronic apparatus including a transceiver, a processor, and one or more memories configured to store one or more instructions, and the one or more instructions may be configured to, when executed, cause the processor to, for a lithium-sulfur battery, obtain a plurality of first voltages measured during a first time period and a plurality of second voltages measured during a second time period subsequent to the first time period, based on a first average voltage, which is an average of the plurality of first voltages, and a second average voltage, which is an average of the plurality of second voltages, identify a first rate of change of an average voltage with respect to a time, based on the first rate of change, determine whether to accumulate a number of times for diagnosing a state of charge of the lithium-sulfur battery, and based on the accumulated number of times, diagnose the state of charge of the lithium-sulfur battery.

The one or more instructions according to an example embodiment may be configured to, when executed, cause the processor to, if the first rate of change is a negative value, determine to accumulate the number of times.

The one or more instructions according to an example embodiment may be configured to, when executed, cause the processor to calculate the first rate of change based on a difference between an average value of time points included in the first time period and an average value of time points included in the second time period and a difference between the first average voltage and the second average voltage.

According to an example embodiment, the difference between the average value of the time points included in the first time period and the average value of the time points included in the second time period may be a value obtained by subtracting the average value of the time points included in the first time period from the average value of the time points included in the second time period, and the difference between the first average voltage and the second average voltage may be a value obtained by subtracting the first average voltage from the second average voltage.

The one or more instructions according to an example embodiment may be configured to, when executed, cause the processor to, if a sum of the accumulated number of times corresponds to a threshold value, diagnose the state of charge of the lithium-sulfur battery.

According to an example embodiment, the state of charge may be diagnosed as a charging delay state with a high risk of ignition.

The one or more instructions according to an example embodiment may be configured to, when executed, cause the processor to repeat the operation of determining whether to accumulate the number of times based on a rate of change of an average voltage with respect to a time until a sum of the number of times corresponds to a threshold value.

According to an example embodiment, each of the plurality of first voltages and the plurality of second voltages may include a preset number of voltages measured at a predetermined time interval.

According to an example embodiment, provided is a method, performed by an electronic apparatus, of diagnosing a state of charge of a lithium-sulfur battery, the method including, for a lithium-sulfur battery, obtaining a plurality of first voltages measured during a first time period and a plurality of second voltages measured during a second time period subsequent to the first time period, based on a first average voltage, which is an average of the plurality of first voltages, and a second average voltage, which is an average of the plurality of second voltages, identifying a first rate of change of an average voltage with respect to a time, based on the first rate of change, determining whether to accumulate a number of times for diagnosing a state of charge of the lithium-sulfur battery, and based on the accumulated number of times, diagnosing the state of charge of the lithium-sulfur battery, and the second average voltage may be an average of a plurality of second voltages of the lithium-sulfur battery, which are measured during a second time previous to the first time.

According to an example embodiment, provided is a non-transitory computer-readable recording medium having a program for executing a method of diagnosing a state of charge of a lithium-sulfur battery on a computer, and the method may include, for a lithium-sulfur battery, obtaining a plurality of first voltages measured during a first time period and a plurality of second voltages measured during a second time period subsequent to the first time period, based on a first average voltage, which is an average of the plurality of first voltages, and a second average voltage, which is an average of the plurality of second voltages, identifying a first rate of change of an average voltage with respect to a time, based on the first rate of change, determining whether to accumulate a number of times for diagnosing a state of charge of the lithium-sulfur battery, and based on the accumulated number of times, diagnosing the state of charge of the lithium-sulfur battery, and the second average voltage may be an average of a plurality of second voltages of the lithium-sulfur battery, which are measured during a second time previous to the first time.

### Effects of the Invention

According to the present disclosure, it is possible to diagnose an extreme charging delay state with a high risk of ignition even if a charging delay occurs initially in charging of a lithium-sulfur battery.

Further, according to the present disclosure, it is possible to diagnose a charging delay state of a lithium-sulfur battery in real time.

Effects of the present disclosure are not limited to those described above, and other effects not mentioned herein may be clearly understood by those skilled in the art from the appended claims.

### Brief Description of Drawings

FIG. 1 illustrates a block diagram of an electronic apparatus according to an example embodiment.
FIG. 2 illustrates a flowchart of a method of diagnosing a state of charge of a lithium-sulfur battery according to an example embodiment.
FIG. 3 illustrates a graph of capacity based on a charging and discharging test of a lithium-sulfur battery according to an example embodiment.
FIG. 4 illustrates a graph of a rate of change of voltage based on a method of diagnosing a state of charge of a lithium-sulfur battery according to an example embodiment.
FIG. 5 illustrates the logic of diagnosing a state of charge of a lithium-sulfur battery according to an example embodiment.

### Mode for Carrying Out the Invention

Terms used in example embodiments are selected from currently widely used general terms when possible while considering the functions in the present disclosure, but the terms may vary depending on the intention of those skilled in the art, precedents, and the emergence of new technology. Further, in particular cases, there are also terms arbitrarily selected by the applicant, and in these cases, the meaning will be described in detail in the corresponding descriptions. Therefore, the terms used in the present disclosure are not to be construed simply as their designations but based on the meanings of the terms and the overall context of the present disclosure.

Throughout the specification, when a part is described as "comprising or including" a component, it does not exclude another component but may further include another component unless otherwise stated. Further, terms such as "... unit or part" and "... module" described herein mean a unit that processes at least one function or operation, which may be implemented as hardware, software, or a combination thereof.

The expression "at least one of a, b, and c" described throughout the specification may include "a alone," "b alone," "c alone," "a and b," "a and c," "b and c," or "all of a, b, and c."

Hereinafter, example embodiments of the present disclosure will be described in detail with reference to the accompanying drawings so that example embodiments may be easily implemented by those skilled in the art. However, the present disclosure may be implemented in many different forms and is not limited to example embodiments described herein.

Hereinafter, with reference to the drawings, example embodiments of the present disclosure related to an electronic apparatus for diagnosing a state of charge of a lithium-sulfur battery are described in detail.

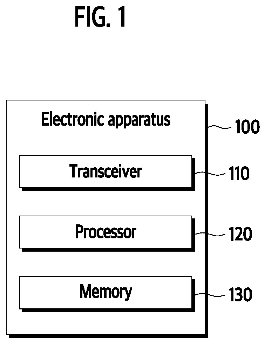

FIG. 1 illustrates a block diagram of an electronic apparatus according to an example embodiment.

Referring to FIG. 1, according to an example embodiment, an electronic apparatus 100 may include a transceiver 110, a processor 120, and a memory 130. FIG. 1 illustrates elements of the electronic apparatus 100 related to example embodiments. Therefore, it may be understood by those skilled in the art that other general-purpose elements may be further included in addition to the elements illustrated in FIG. 1.

For example, the electronic apparatus 100 may include a communication device including one or more transceivers 110, an input part, and an output part. The communication device may be a device for performing wired and wireless communications and may communicate with an external electronic device. The external electronic device may be a terminal or a server. In addition, a communication technology used by the communication device may include global system for mobile communication (GSM), code division multi-access (CDMA), long term evolution (LTE), fifth generation (5G), wireless local area network (WLAN), wireless-fidelity (Wi-Fi), Bluetooth, radio frequency identification (RFID), infrared data association (IrDA), ZigBee, or near field communication (NFC). The input part may be, for example, a keypad or a keyboard of a traditional form, a mouse, a microphone to which a voice signal is inputted, a camera, and other various forms of input means that sense or receive various forms of user inputs. The output part may be, for example, a display for outputting a video, and a speaker for outputting a sound, a haptic device for generating vibrations, and other various forms of output means.

According to an example embodiment, the electronic apparatus 100 may be an apparatus for charging and discharging a lithium-sulfur battery. Specifically, the electronic apparatus 100 may be connected to the lithium-sulfur battery and apply a charge or discharge current to the battery to charge or discharge and activate the battery. The electronic apparatus 100 may simultaneously perform charging and discharging of the lithium-sulfur battery and conduct performance and lifetime evaluation on the lithium-sulfur battery or perform a test for operation of the lithium-sulfur battery. Further, the electronic apparatus 100 may obtain battery voltage data in the process of charging and discharging the lithium-sulfur battery. The voltage data may be obtained through the transceiver 110, for example, from a battery management system (BMS).

According to another example embodiment, the electronic apparatus 100 may be a BMS or may be a server for analyzing a variety of battery information.

The processor 120 may control overall operations of the electronic apparatus 100 and process data and signals. The processor 120 may include at least one hardware unit. Further, the processor 120 may operate by one or more software modules generated by executing program codes stored in the memory 130. Since the processor 120 may include a memory, the processor 120 may control the overall operations of the electronic apparatus 100 and process data and signals by executing program codes stored in the memory.

The processor 120 may be implemented as a computer or a similar device based on hardware, software, or a combination thereof. The processor 120 may be implemented in hardware in the form of an electronic circuit for performing a control function by processing electrical signals and may be implemented in software in the form of a program for operating the processor 120 in hardware. Meanwhile, unless otherwise mentioned in the following description, the operation of an electronic apparatus may be construed as being performed by the control of the processor 120. In other words, if modules implemented in a system of diagnosing a state of charge of a lithium-sulfur battery are executed, the modules may be construed as controlling the processor 120 to perform the following operations of the electronic apparatus 100.

The memory 130 may store a variety of information. The memory 130 may store data temporarily or semi-permanently. For example, data related to an operating system (OS) for operating the electronic apparatus 100 may be stored in the memory 130 of the electronic apparatus 100. Examples of the memory 130 may include a hard disk drive (HDD), a solid state drive (SSD), flash memory, read-only memory (ROM), and random-access memory (RAM). The memory 130 may be provided in an embedded type or a detachable type.

In summary, various example embodiments may be implemented through various means. For example, various example embodiments may be implemented by hardware, firmware, software, or a combination thereof.

If implemented by hardware, a method according to various example embodiments may be implemented by one or more application specific integrated circuits (ASICs), digital signal processors (DSPs), digital signal processing devices (DSPDs), programmable logic devices (PLDs), field programmable gate arrays (FPGAs), processors, controllers, microcontrollers, or microprocessors.

If implemented by firmware or software, a method according to various example embodiments may be implemented in the form of a module, a procedure, or a function for performing functionalities or operations described above. For example, software code may be stored in a memory and executed by a processor. The memory may be located inside or outside the processor and may exchange data with the processor through various means previously known.

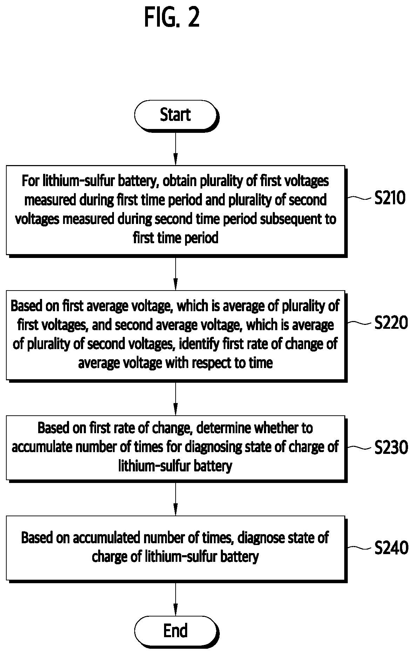

FIG. 2 illustrates a flowchart of a method of diagnosing a state of charge of a lithium-sulfur battery according to an example embodiment.

In operation S210, the electronic apparatus 100 may, for a lithium-sulfur battery, obtain a plurality of first voltages measured during a first time period and a plurality of second voltages measured during a second time period subsequent to the first time period. As an example, each of the plurality of first voltages and the plurality of second voltages may include a preset number of voltages measured at a predetermined time interval. Here, the preset number may be, for example, 10. As another example, each of the plurality of first voltages and the plurality of second voltages may include the preset number of voltages, but an interval between time points in which each voltage is measured may not be uniform.

In operation S220, the electronic apparatus 100 may, based on a first average voltage, which is an average of the plurality of first voltages, and a second average voltage, which is an average of the plurality of second voltages, identify a first rate of change of an average voltage with respect to a time. For example, the electronic apparatus 100 may calculate the first rate of change based on a difference between an average value of time points included in the first time period and an average value of time points included in the second time period and a difference between the first average voltage and the second average voltage. As above, by deriving an average value of a predetermined number of voltages included in a particular time period to calculate the first rate of change, a noise due to a voltage transient that may be included in the particular time period may be removed or mitigated. Further, by deriving an average value based on a relatively small amount of data, compared to using a large amount of data such as charging and discharging cycles, calculation costs for diagnosing a state of charge may be greatly reduced.

According to an example embodiment, the difference between the average value of the time points included in the first time period and the average value of the time points included in the second time period may be, for example, a value obtained by subtracting the average value of the time points included in the first time period from the average value of the time points included in the second time period, and the difference between the first average voltage and the second average voltage may be, for example, a value obtained by subtracting the first average voltage from the second average voltage. Meanwhile, when t denotes a particular time period, a process of calculating a rate of change of an average voltage in time period t may be represented, for example, as in Equation 1 below. [Equation 1] $Δ {V}_{t} = \frac{{V}_{avg , t} - {V}_{avg , t - 1}}{{T}_{avg , t} - {T}_{avg , t - 1}}$ *where* ${V}_{avg , t} = \frac{{\sum }_{k = 0}^{9} {V}_{10 t + k}}{10}$ *and* ${T}_{avg , t} = \frac{{\sum }_{k = 0}^{9} {T}_{10 t + k}}{10}$ (*t =* 0, 1, 2 , ... )

In Equation 1 above,
Δ*Vₜ*
denotes a rate of change with respect to time period t,
   *V_{avg,t}*
denotes an average voltage of time period t,
   *V*_{*avg,t-*1}
denotes an average voltage of time period t-1 previous to time period t,
   *T_{avg,t}*
denotes an average value of time points (T) included in time period t, and
   *T*_{*avg,t-*1}
denotes an average value of time points included in time period t-1. In other words, when each time period includes 10 time points and 10 pieces of voltage data measured in each time point, an average voltage of each time period and an average value of time points included in each time period may be calculated, and based thereon, a rate of change of an average voltage with respect to a time may be derived. Therefore, a rate of change of an average voltage with respect to a time, which is calculated through a process as above, may have the meaning of a slope of an average voltage with respect to a time.

In operation S230, the electronic apparatus 100 may, based on the first rate of change, determine whether to accumulate a number of times for diagnosing a state of charge of the lithium-sulfur battery. For example, the electronic apparatus 100 may, if the first rate of change is a negative value, determine to accumulate the number of times. In other words, if an average voltage of a particular time period has a value lower than an average voltage of a previous time period, the number of times may be accumulated. This may be a condition for accumulating the number of times, which is set based on a rate of change of an average voltage generally having a negative value when a degree of charging delay described below is extreme. Meanwhile, it may be clearly understood by those skilled in the art that a threshold value that serves as a criterion for accumulating the number of times is not limited thereto and may be variously set according to example embodiments.

In operation S240, the electronic apparatus 100 may, based on the accumulated number of times, diagnose the state of charge of the lithium-sulfur battery. For example, the electronic apparatus 100 may, if a sum of the accumulated number of times corresponds to a threshold value, diagnose the state of charge of the lithium-sulfur battery. Here, the state of charge of the lithium-sulfur battery may be diagnosed as a charging delay state with a high risk of ignition. In other words, the electronic apparatus 100 may, based on the sum of the accumulated number of times, diagnose whether the lithium-sulfur battery is in an extreme charging delay state with a high risk of ignition. The charging delay state may refer to a state where the voltage of a battery does not increase or slowly increases during charging, and thus, charging capacity and time increase and the voltage of the battery may not reach a target voltage, and the state of charge diagnosed according to the present disclosure may refer to an extreme charging delay state with a very high possibility of ignition among charging delay states. Meanwhile, the threshold value as a condition for diagnosing the state of charge may be a value derived through an experiment, and for example, may be 5.

According to an example embodiment, the electronic apparatus 100 may repeat an operation of determining whether to accumulate the number of times for diagnosing the state of charge of the lithium-sulfur battery based on a rate of change of the average voltage as described above until the sum of the number of times corresponds to the threshold value. In other words, the electronic apparatus 100 may repeat operation S210 through operation S230 until the sum of the accumulated number of times corresponds to the threshold value. If the sum of the accumulated number of times corresponds to the threshold value, the electronic apparatus 100 may diagnose the occurrence of extreme charging delay of the lithium-sulfur battery and provide a notification thereof.

Therefore, without the process of obtaining and analyzing data related to battery capacity during multiple charging and discharging cycles, the electronic apparatus 100 may diagnose a cell having a tendency for extreme charging delay in real time based on the trend of a voltage change in a lithium-sulfur battery within a current cycle. Accordingly, a situation with a risk of ignition that occurs in an initial cycle may be diagnosed and handled in an effective and economical manner, and the present disclosure may allow a faster response to all charging delay situations.

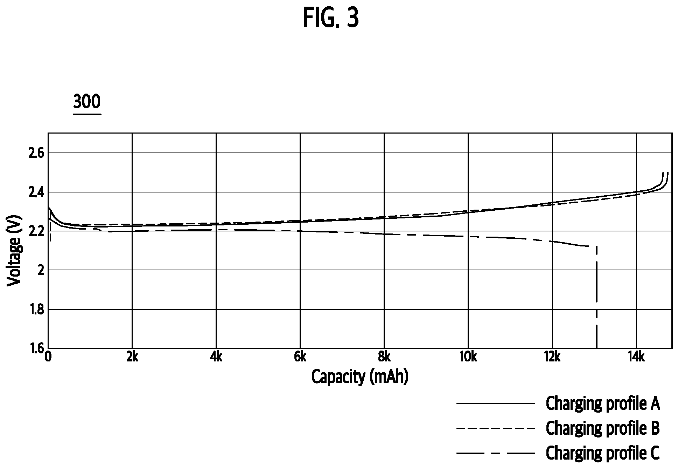

FIG. 3 illustrates a graph 300 of capacity based on a charging and discharging test of a lithium-sulfur battery according to an example embodiment.

Referring to FIG. 3, the graph 300 of capacity may represent some charging profiles during charging and discharging cycles of a cell ignited after a charging delay occurs while performing a charging and discharging test on a lithium-sulfur battery. The graph 300 of capacity is a graph having a capacity (mAh) of a battery on the x-axis and a voltage (V) on the y-axis, and on the graph, charging profile B may be a profile where a slight charging delay occurs with respect to charging profile A, and compared thereto, a profile where an extreme charging delay occurs and leads to ignition may be charging profile C. To prevent ignition as in charging profile C, various safety diagnosis manners are discussed, but in most cases, a voltage abnormality of a current cycle is diagnosed based on a comparison with previous charging and discharging cycle data, and thus, there are limitations in that diagnosing an issue with charging delay that occurs initially during a cycle is difficult due to insufficient data of a previous cycle.

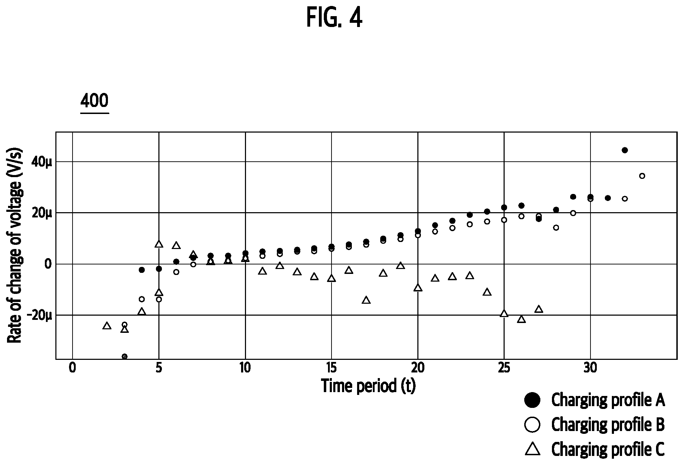

FIG. 4 illustrates a graph 400 of a rate of change of voltage based on a method of diagnosing a state of charge of a lithium-sulfur battery according to an example embodiment.

The graph 400 of the rate of change of voltage in FIG. 4 represents the trend (slope) of a rate of change of an average voltage with respect to a time by a method of diagnosing a state of charge according to the present disclosure, based on the same charging profile data as FIG. 3. In the graph 400 of the rate of change of voltage, the x-axis may indicate time period t including a plurality of time points (T), and the y-axis may indicate a rate of change of voltage (V/s) obtained by dividing a voltage value by a time. The graph 400 of the rate of change of voltage shows that the number of times a rate of change of an average voltage with respect to the time in each of charging profile A and charging profile B has a negative value is less than 5, whereas the number of times a rate of change of an average voltage with respect to the time in charging profile C has a negative value is greater than or equal to 5. Therefore, using the graph 400 of the rate of change of voltage as above, an extreme charging delay may be initially and promptly diagnosed.

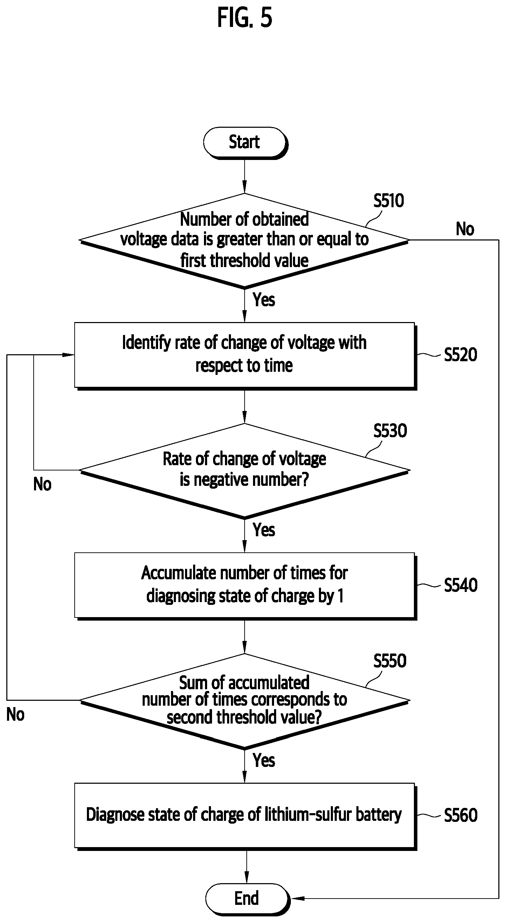

FIG. 5 illustrates the logic of diagnosing a state of charge of a lithium-sulfur battery according to an example embodiment.

In operation S510, the electronic apparatus 100 may identify whether the number of obtained voltage data of a lithium-sulfur battery is greater than or equal to a first threshold value. The first threshold value may be set to, for example, 70. In other words, in an example where a single time period includes 10 pieces of voltage data, the electronic apparatus 100 may identify whether pieces of voltage data of the lithium-sulfur battery corresponding to at least 7 time periods are obtained. As above, the electronic apparatus 100 may identify whether minimum pieces of voltage data are obtained before diagnosing a state of charge.

If it is identified that minimum pieces of data for diagnosing the state of charge are obtained, the electronic apparatus 100 may identify a rate of change of voltage of the lithium-sulfur battery with respect to a time in operation S520. In contrast, if pieces of voltage data of a number greater than or equal to the first threshold value are not obtained, the electronic apparatus 100 may not perform operation S520 and the following operations and may continue to obtain voltage data.

In operation S530, the electronic apparatus 100 may identify whether the rate of change of voltage is a negative number.

If the identified rate of change of voltage is a negative number, the electronic apparatus 100 may accumulate the number of times for diagnosing the state of charge by 1 in operation S540. In contrast, if the identified rate of change of voltage is not a negative number, the electronic apparatus 100 may perform operation S520 again.

In operation S550, the electronic apparatus 100 may identify whether a sum of the accumulated number of times corresponds to a second threshold value. The second threshold value may be, for example, 5.

If the sum of the accumulated number of times corresponds to the second threshold value, the electronic apparatus 100 may diagnose the state of charge of the lithium-sulfur battery in operation S560. In contrast, if the sum of the accumulated number of times does not correspond to the second threshold value, the electronic apparatus 100 may perform operation S520 and the following again. In other words, until the sum of the accumulated number of times corresponds to the second threshold value, the electronic apparatus 100 may repeatedly perform operation S520 through operation S550.

The electronic apparatus according to the above-described example embodiments may include a processor, a memory for storing and executing program data, a permanent storage such as a disk drive, a communication port that communicates with an external device, and a user interface device such as a touch panel, a key, and a button. Methods implemented by software modules or algorithms may be stored in a computer-readable recording medium as computer-readable codes or program instructions executable on the processor. Here, the computer-readable recording medium includes a magnetic storage medium (for example, read-only memory (ROM), random-access memory (RAM), floppy disks, and hard disks) and an optically readable medium (for example, compact disc read-only memory (CD-ROM) and digital versatile discs (DVDs)). The computer-readable recording medium may be distributed among network-connected computer systems, so that the computer-readable codes may be stored and executed in a distributed manner. The medium may be readable by a computer, stored in a memory, and executed on a processor.

The example embodiments may be represented by functional block elements and various processing steps. The functional blocks may be implemented in any number of hardware and/or software configurations that perform specific functions. For example, an example embodiment may adopt integrated circuit configurations, such as memory, processing, logic, and/or look-up table, which may execute various functions by the control of one or more microprocessors or other control devices. Similar to elements being implemented as software programming or software elements, the example embodiments may be implemented in a programming or scripting language such as C, C++, Java, and assembler, including various algorithms implemented as a combination of data structures, processes, routines, or other programming constructs. Functional aspects may be implemented in an algorithm running on one or more processors. Further, the example embodiments may adopt the existing art for electronic environment setting, signal processing, and/or data processing. Terms such as "mechanism," "element," "means," and "configuration" may be used broadly and are not limited to mechanical and physical configurations. The terms may include the meaning of a series of routines of software in association with a processor or the like.

The above-described example embodiments are examples, and other example embodiments may be implemented within the scope of the appended claims.

## Claims

1. An electronic apparatus comprising:
a transceiver;
a processor; and
one or more memories configured to store one or more instructions,
wherein the one or more instructions are configured to, when executed, cause the processor to:
for a lithium-sulfur battery, obtain a plurality of first voltages measured during a first time period and a plurality of second voltages measured during a second time period subsequent to the first time period;
based on a first average voltage, which is an average of the plurality of first voltages, and a second average voltage, which is an average of the plurality of second voltages, identify a first rate of change of an average voltage with respect to a time;
based on the first rate of change, determine whether to accumulate a number of times for diagnosing a state of charge of the lithium-sulfur battery; and
based on the accumulated number of times, diagnose the state of charge of the lithium-sulfur battery.

2. The electronic apparatus of claim 1,
wherein the one or more instructions are configured to, when executed, cause the processor to:
if the first rate of change is a negative value, determine to accumulate the number of times.

3. The electronic apparatus of claim 1,
wherein the one or more instructions are configured to, when executed, cause the processor to:
calculate the first rate of change based on a difference between an average value of time points included in the first time period and an average value of time points included in the second time period and a difference between the first average voltage and the second average voltage.

4. The electronic apparatus of claim 3,
wherein the difference between the average value of the time points included in the first time period and the average value of the time points included in the second time period is
a value obtained by subtracting the average value of the time points included in the first time period from the average value of the time points included in the second time period, and
wherein the difference between the first average voltage and the second average voltage is
a value obtained by subtracting the first average voltage from the second average voltage.

5. The electronic apparatus of claim 1,
wherein the one or more instructions are configured to, when executed, cause the processor to:
if a sum of the accumulated number of times corresponds to a threshold value, diagnose the state of charge of the lithium-sulfur battery.

6. The electronic apparatus of claim 1,
wherein the state of charge is diagnosed as a charging delay state with a high risk of ignition.

7. The electronic apparatus of claim 1,
wherein the one or more instructions are configured to, when executed, cause the processor to:
repeat the operation of determining whether to accumulate the number of times based on a rate of change of an average voltage with respect to a time until a sum of the number of times corresponds to a threshold value.

8. The electronic apparatus of claim 1,
wherein each of the plurality of first voltages and the plurality of second voltages includes a preset number of voltages measured at a predetermined time interval.

9. A method, performed by an electronic apparatus, of diagnosing a state of charge of a lithium-sulfur battery, the method comprising:
for a lithium-sulfur battery, obtaining a plurality of first voltages measured during a first time period and a plurality of second voltages measured during a second time period subsequent to the first time period;
based on a first average voltage, which is an average of the plurality of first voltages, and a second average voltage, which is an average of the plurality of second voltages, identifying a first rate of change of an average voltage with respect to a time;
based on the first rate of change, determining whether to accumulate a number of times for diagnosing a state of charge of the lithium-sulfur battery; and
based on the accumulated number of times, diagnosing the state of charge of the lithium-sulfur battery,
wherein the second average voltage is an average of a plurality of second voltages of the lithium-sulfur battery, which are measured during a second time previous to the first time.

10. A non-transitory computer-readable recording medium having a program for executing the method of claim 9 on a computer.
